# EUROPEAN PATENT SPECIFICATION

(11) **EP 1 389 754 B1**
(45) Date of publication and mention of the grant of the patent: **11.10.2006**
(21) Application number: 02255656.7
(22) Date of filing: 14.08.2002
(51) Int. Cl.: G06F 1/20, H05K 7/20

(54) **Heat-dissipating fan with manually adjustable speed-setting**
Hitze verbreitener Ventilator mit von Hand verstellbarer Geschwindigkeitseinstellung
Ventilateur pour diffusion de chaleur avec réglage de vitesse manuel

(43) Date of publication of application: 18.02.2004
(73) Proprietor: Enermax, Technology Corporation, Taoyuan (TW)
(72) Inventor: Su, Steven, Taoyuan (TW)
(74) Representative: Pratt, David Martin

(56) References cited:
- EP-A- 1 026 571
- US-B1- 6 396 675

## Description

### BACKGROUND OF THE INVENTION:

Due to the fast development of electronic technology in the recent years, the equipments from daily utilities to the commercials and industrials use electronic technology without exception. Obviously, electronic products are related to electricity, since to electricity related, the equipments generate heat certainly, especially the higher the efficiency, the faster the execution speed of the equipments, the more the problems of temperature over-heat. Improper over-heat in the equipments readily damages the equipments or their elements such as "personal computer" products are the best examples.

At present, in most of the equipments that generate heat, the most efficient and most general method to over-come over-heat is the supplement of heat-dissipating fans in working environment in the equipment or on the specific elements readily generate heat, which, except the temperature of said equipments being properly controlled, achieving proper convection to the entire equipment or system, gaining proper temperature control in the interior of the equipment, accordingly prevent crash or damage resulting from improper over-heat, even accidental fire.

The speed of conventional independent heat-dissipating fan is set-up by the factory during production. Usually, users cannot set-up or adjust its speed individually, unless an extra adjuster-button is added after set-up, in order to change or adjust the speed of the fan. As is known, the most generally-used rectangular frame-body heat-dissipating fan is provided with two to four perforated bolt-hole positions at corners thereof, for the fan to be fixed at the needed position by bolts.

Known heat-dissipating fans are disclosed in US-B-6396675 and EP-A-1026571.

The present invention provides a heat-dissipating fan having a manually-adjustable speed-adjusting switch, the fan having a rectangular frame provided with at least two bolt holes in the front or rear side corners for use in fixing the fan to a support structure, the speed-adjusting switch having a revolving handle or push button exposed outside of the frame, the fan further comprising a power cord for the speed-adjusting switch, which power cord is connected to the power cord of the heat-dissipating fan, whereby a user can control the speed of the heat-dissipating fan, characterised in that the rear end of the speed-adjusting switch is installed and fixed into one of the bolt holes.

Accordingly, a speed-adjusting switch can be associated with any of the original bolt-holes of the fan, without changing or destroying the size, method of use, method of fixation, and the structure of the original heat-dissipating fan. Typically the bolt-holes are provided in the corners of the front or rear side of the fan.

At present, some heat-dissipating fans are provided with a temperature-detecting and automatic speed-adjusting thermal resistor, to provide low-speed revolution when entering a sleeping state, or to provide high-speed revolution with increased heat dissipation when the ambient temperature is elevated, the working principle being to provide a thermal resistor at the power supply end of the fan, to slow or accelerate the revolution of the fan by the change of resistance value. The present invention further adapts the original temperature-detecting thermal resistor, to achieve a two-fold function of speed-adjustment.

The invention will now be described in greater detail, by way of example, with reference to the drawings, in which: -

### BRIEF DESCRIPTION OF THE DRAWINGS:

Fig. 1 is the front view of the simplified model of the present invention with manual adjustment for setting-up of speed of the heat-dissipating fan.
Fig. 2 is the front view of present invention used in heat-dissipating fan with thermal resistor manually adjustable for speed set-up.
Fig.3A is the front view of a step-wise adjuster-revolving-button in the present invention in heat-dissipating fan with manually adjustable setting-up for speed.
Fig.3B is the lateral view of a step-wise adjuster-revolving-button in the present invention in heat-dissipating fan with manually adjustable setting-up for speed.
Fig.4A is the front view of a step-less adjuster-revolving-button in the present invention in heat-dissipating fan with manually adjustable setting-up for speed.
Fig.4B is the lateral view of a step-less adjuster-revolving-button in the present invention in heat-dissipating fan with manually adjustable setting-up for speed.
Fig.5A is the front view of a push-button adjuster-switch in the present invention in heat-dissipating fan with manually adjustable setting-up for speed.
Fig.5B is the lateral view of a push-button adjuster-switch in the present invention in heat-dissipating fan with manually adjustable setting-up for speed.
Fig.6 is the perspective view of an embodiment of the present invention, a heat-dissipating fan with manually adjustable setting-up for speed used in personal computer.
Fig.7 is the rear view of an embodiment of the present invention, a heat-dissipating fan with manually adjustable setting-up for speed used in computer personal.

### DETAILED DESCRIPTION OF THE EMBODIMENT AND STRUCTURE

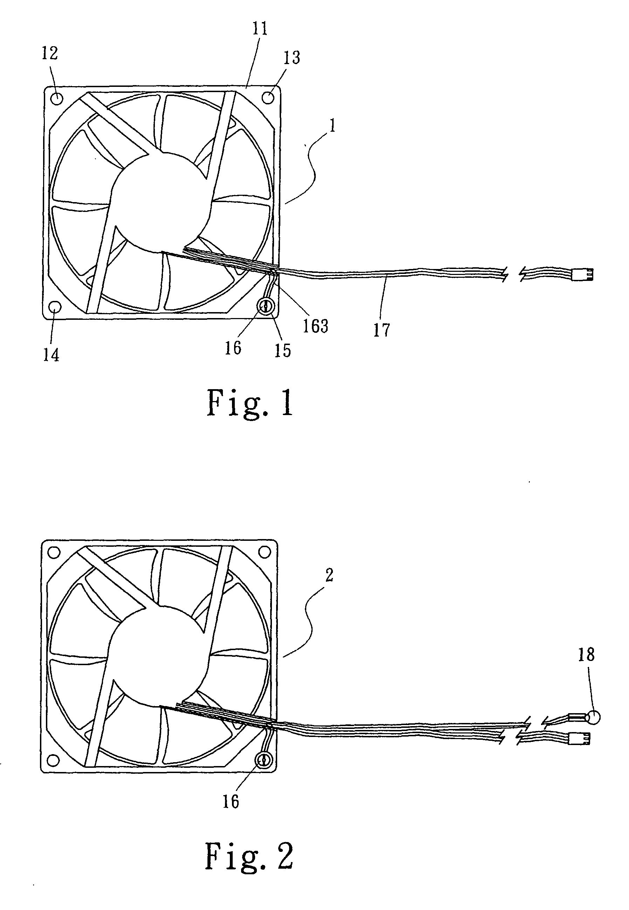

As shown in Fig. 1, the present embodiment used, in one of the bolt-holes 12, 13, 14, 15, at the front side and rear side corners of the frame body 11 of the heat-dissipating fan 1, a speed-adjuster-button or switch 16, with the rear end 161 of the button or switch 16 installed and fixed in the above-mentioned bolt-hole 15, and the revolving handle or push-button 162 of the button or switch exposed outside of the frame body 11, further, the power cord 163 of the speed-adjuster-button or switch 16 connected to the power cord 17 of the fan 1, accordingly, said heat-dissipating fan 1 can, without change or destruction of the original size, method of use, way of fixation and principle of structure, provide the user with setting-up the speed of said heat-dissipating fan individually according to needs directly any time.

As shown in Fig.2, the present invention was contemplated except being used in the above-mentioned generalized simplified model of heat-dissipating fan 1, as well as with the speed-adjuster-button or switch 16 being installed in the same manner on a thermal resistor heat-dissipating fan 2 with a thermal resistor 18, to achieve a 2-fold speed-adjusting function as shown in Fig.2.

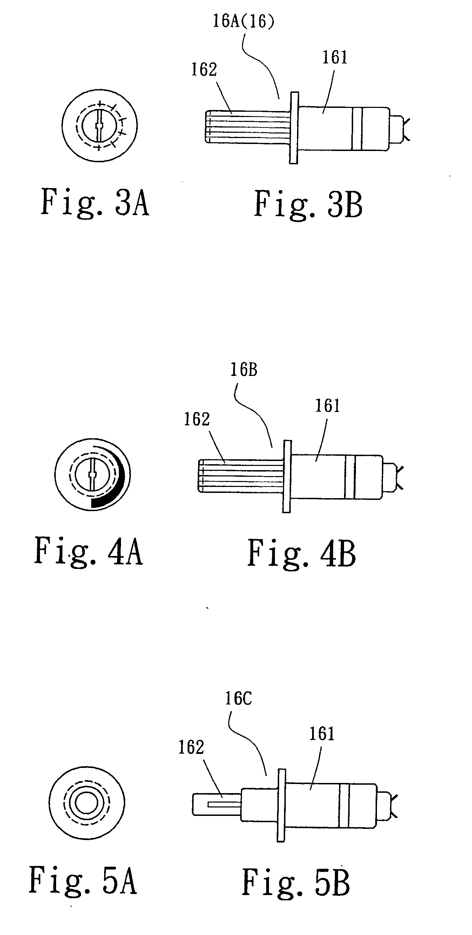

The speed-adjuster-button or switch 16 used by the above-mentioned embodiment of the present invention, which included a step-wise adjuster-button 16A as shown in Fig.3A and 3B, a step-less adjuster-button 16B as shown in Fig.4A and 4B, and the push-button adjuster-button 16C as shown in Fig 5A and 5B, of which the various adjuster-buttons or switches should be included in the present invention.

As described above, the invention, under the principle of without changing or destroying the size, method of use, method of fixation and structure of the original fan 1, after addition of a adjuster-button or switch 16 of various types, can provide the user with manual set-up of the speed of said heat-dissipating fan 1 directly according to needs any time, obviously which improves the efficacy without fear.

Upon implementing the present invention of the device of a heat-dissipating fan 1, the device can be installed anywhere in need of heat-dissipation, which if fixed on a case or in a closed interior space, can be manually set-up or adjusted before installed and bolted fast.

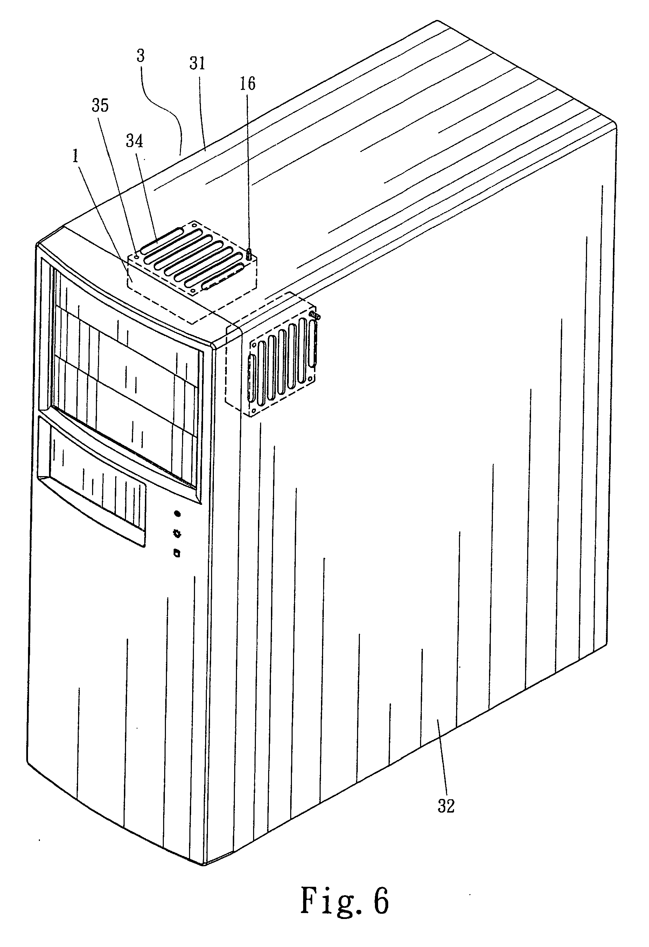

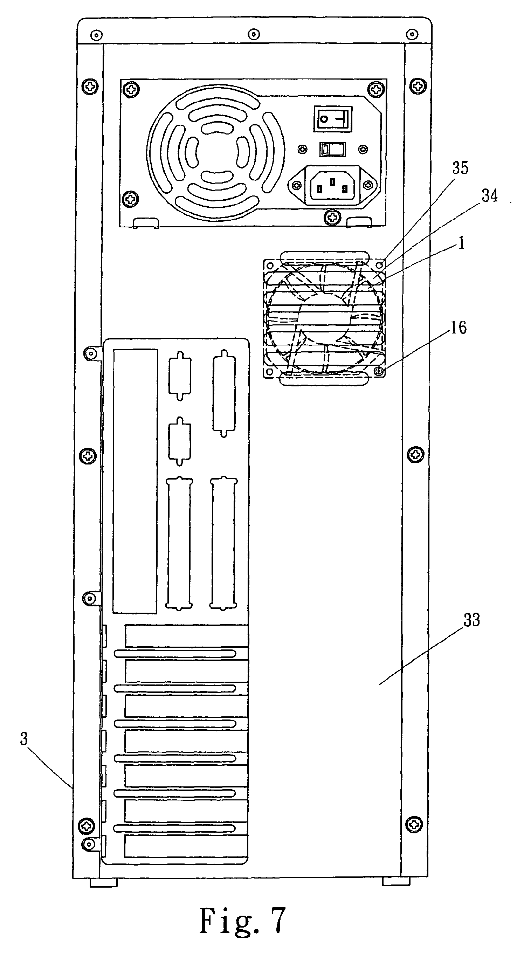

As shown in Fig.6 and 7 the perspective view of the embodiment, the designing conception of the invention also was to install said manually adjustable speed-setup fan 1 in positions close to the shell-case body 3 of a computer, which method was reserving heat-dissipating hole 34, and fan-fixation holes 35 in advance at proper positions on the upward surface 31, lateral surface 32, or rear surface 33 of the case body 3, and to fix the manually adjustable speed-setup heat-dissipating fan 1 on the corresponding position inside the heat-dissipating hole 34, and with the speed-adjusting handle or switch 16 extended to the outside through one of the fixation holes 35, to provide the user with adjusting the speed of the heat-dissipating fan 1 directly with fingers from outside, accordingly, to greatly improve the efficacy of the invention.

## Claims

1. A heat-dissipating fan (1) having a manually-adjustable speed-adjusting switch (16), the fan having a rectangular frame (11) provided with at least two bolt holes (12 to 15) in the front or rear side corners for use in fixing the fan to a support structure, the speed-adjusting switch having a revolving handle or push button (162) exposed outside of the frame, the fan further comprising a power cord (163) for the speed-adjusting switch, which power cord is connected to the power cord (17) of the heat-dissipating fan, whereby a user can control the speed of the heat-dissipating fan, **characterised in that** the rear end (161) of the speed-adjusting switch is installed and fixed into one of the bolt holes.

2. A fan (1) as claimed in claim 1, in which the fan further comprises a thermal resistor (18), thereby having a two-fold speed-adjusting function.

3. A fan (1) as claimed in claim 1, in which said speed-adjusting switch (16) includes a step-wise adjustable revolving-button (16A), a step-less adjustable revolving-button (16B) or a push-button adjuster-switch (10C).

4. A computer comprising a fan (1) as claimed in any one of claims 1 to 3, wherein the fan is fixed to a shell-case body (3) of the computer, at reserved heat-dissipating (34) and fan-fixation holes (35) provided in the case body, thereby to fix the fan relative to the heat-dissipating hole, and with the speed-adjusting switch extending to the outside of the shell-case body through one of the fixation holes, thereby to permit the user to adjust the speed of the fan directly with fingers from the outside of the shell-case body.

## Patentansprüche

1. Wärmeabführendes Gebläse (1) mit einem von Hand einstellbaren Geschwindigkeitseinstellschalter (16), wobei das Gebläse einen rechteckigen Rahmen (11) hat, der mit mindestens zwei Schraubenlöchern (12 bis 15) in den Ecken der Vorder- oder Rückseite zum Befestigen des Gebläses an einer Tragstruktur versehen ist, wobei der Geschwindigkeitseinstellschalter einen Drehgriff oder eine Drucktaste (162) hat, der bzw. die auf der Außenseite des Rahmens offen liegt, wobei das Gebläse ferner ein Stromkabel (163) für den Geschwindigkeitseinstellschalter aufweist, das an das Stromkabel (17) des wärmeabführenden Gebläses angeschlossen ist, wodurch ein Benutzer die Geschwindigkeit des wärmeabführenden Gebläses steuern kann, **dadurch gekennzeichnet, dass** das hintere Ende (161) des Geschwindigkeitseinstellschalters in eines der Schraubenlöcher eingebaut und darin befestigt ist.

2. Gebläse (1) nach Anspruch 1, bei dem das Gebläse ferner einen Wärmewiderstand (18) aufweist und **dadurch** eine zweifache Geschwindigkeitseinstellfunktion hat.

3. Gebläse (1) nach Anspruch 1, bei dem der Geschwindigkeitseinstellschalter (16) einen stufenweise einstellbaren Drehknopf (16a), einen stufenlosen einstellbaren Drehknopf (16b) oder einen Drucktasteneinstellschalter (10c) enthält.

4. Computer mit einem Gebläse (1) nach irgendeinem der Ansprüche 1 bis 3, bei dem das Gebläse an einem Mantelgehäusekörper (3) des Computers an vorhandenen Wärmeabführungs- (34) und Gebläsebefestigungslöchern (35), die in dem Gehäusekörper vorgesehen sind, befestigt ist, um **dadurch** das Gebläse relativ zu dem Wärmeabführungsloch zu fixieren, und wobei der Geschwindigkeitseinstellschalter auf die Außenseite des Mantelgehäusekörpers durch eines der Befestigungslöcher ragt und **dadurch** dem Benutzer gestattet, die Geschwindigkeit des Gebläses direkt mit den Fingern von der Außenseite des Mantelgehäusekörpers einzustellen.

## Revendications

1. Ventilateur pour diffusion de chaleur (1) ayant un commutateur de réglage de vitesse réglable manuellement (16), le ventilateur ayant un châssis rectangulaire (11) doté d'au moins deux trous de boulon (12 à 15) dans les coins avant ou arrière pour être utilisés pour la fixation du ventilateur sur une structure de support, le commutateur de réglage de vitesse ayant un bouton tournant ou poussoir (162) exposé à l'extérieur du châssis, le ventilateur comprenant en outre un cordon d'alimentation (163) pour le commutateur d'ajustement de vitesse, lequel cordon d'alimentation est connecté au cordon d'alimentation (17) du ventilateur diffuseur de chaleur, par lequel un utilisateur peut contrôler la vitesse du ventilateur de diffusion de chaleur, **caractérisé en ce que** l'extrémité arrière (161) du commutateur de réglage de vitesse est installée et fixée dans l'un des trous de boulon.

2. Ventilateur (1) selon la revendication 1, dans lequel le ventilateur comprend en outre une thermo-résistance (18) ayant ainsi une double fonction de réglage de vitesse.

3. Ventilateur (1) selon la revendication 1, dans lequel le commutateur de réglage de vitesse (16) inclut un bouton rotatif réglable par pas (16A), un bouton rotatif ajustable en continu (16B) ou un bouton-poussoir de réglage (10C).

4. Ordinateur comprenant un ventilateur (1) tel que revendiqué dans l'une des revendications 1 à 3, dans lequel le ventilateur est fixé à un corps de châssis (3) de l'ordinateur, au niveau de trous de diffusion réservés (34) et de trous de fixation du ventilateur (35) ménagés dans le corps de châssis, permettant de fixer le ventilateur par rapport aux trous de diffusion de la chaleur et, avec le commutateur de réglage de vitesse s'étendant vers l'extérieur du corps de châssis par l'un des trous de fixation, permettant ainsi à l'utilisateur de régler la vitesse du ventilateur directement avec ses doigts depuis l'extérieur du corps de châssis.
